(19) Europäisches Patentamt / European Patent Office / Office européen des brevets

(11) **EP 2 779 444 B1**

(12) **EUROPEAN PATENT SPECIFICATION**

(45) Date of publication and mention
of the grant of the patent:
**27.12.2017 Bulletin 2017/52**

(51) Int Cl.:
*H03F 3/45* [(2006.01)]     *H04N 5/363* [(2011.01)]

(21) Application number: **14000727.9**

(22) Date of filing: **28.02.2014**

(54) **Leakage Compensation For Switched Capacitor Integrators**

Leakageausgleich für geschaltete Kondensatorintegratoren

Compensation de fuite d'intégrateurs de condensateur commuté

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **13.03.2013 US 201361780727 P**
**26.04.2013 US 201313871981**

(43) Date of publication of application:
**17.09.2014 Bulletin 2014/38**

(73) Proprietor: **Linear Technology Corporation**
**Milpitas, CA 95035-7417 (US)**

(72) Inventor: **Trampitsch, Gerd**
**85774 Unterföhring (DE)**

(74) Representative: **Müller-Boré & Partner**
**Patentanwälte PartG mbB**
**Friedenheimer Brücke 21**
**80639 München (DE)**

(56) References cited:
**EP-A1- 0 293 020**     **US-B1- 6 172 631**

- FULOP T ET AL: "Switched-capacitor biquad building block with offset-insensitive time-continuous feedback integrators", CIRCUITS AND SYSTEMS, 1988., IEEE INTERNATIONAL SYMPOSIUM ON, IEEE, 7 June 1988 (1988-06-07), page 1257, XP032410172, DOI: 10.1109/ISCAS.1988.15156
- KAJITA T ET AL: "Correlated double sampling integrator insensitive to parasitic capacitance", ELECTRONICS LETTERS, IEE STEVENAGE, GB, vol. 37, no. 3, 1 February 2001 (2001-02-01), pages 151-153, XP006016250, ISSN: 0013-5194, DOI: 10.1049/EL:20010130

EP 2 779 444 B1

**Description**

**TECHNICAL FIELD**

This disclosure relates to switched capacitor (SC) circuits, and more particularly, to a correlated double sampling (CDS) switched capacitor integrator.

**DESCRIPTION OF RELATED ART**

In recent years there has been an effort to improve methods of and circuits for acquiring analog signals and converting them to the digital domain. Although real world signals are analog, it is often desirable to convert them to the digital domain using analog-to-digital converters (ADCs). For example, sampling systems are frequently found in popular consumer electronic devices such as MP3 players, DVD players and cellular telephones. Other popular uses of sampling systems include those related to data acquisition, test and measurement, and control system applications. Sampling systems and sample-based technology may be found in the electronic components used to construct such devices, which include analog-to-digital converters, switched capacitor networks, signal acquisition circuitry, comparators, and others.

Analog processing circuits generally include a gain stage configured to amplify the input analog signal. Switched-capacitor gain circuits are frequently used to provide such amplification. Typical switched-capacitor gain circuits include an amplifier and a set of capacitors to store the input signal.

Although present switched-capacitor gain circuits generally perform their function, they do have imperfections. For example, flicker noise, finite gain of the amplifier, and DC offsets detrimentally affect the achievable accuracy of switched-capacitor gain circuits.

To compensate for some switched-capacitor gain circuits, a technique known as correlated double sampling (CDS) is used. CDS is a method to measure electrical values such as voltages or currents that allows removing of undesired offset. The output of a sensor is measured twice: (i) in a first (e.g., known) condition and (ii) in a second (e.g., unknown) condition. The value measured from the first condition is subtracted from the second condition to generate a value with a known relation to the physical quantity being measured. This technique effectively doubles the gain of the charge sharing switched capacitor operational amplifier, while adding extra phase.

Although CDS techniques may improve the achievable accuracy of switched capacitor circuits, they come at a cost. Parasitic capacitances of the prior art integration switches may cause leaky integrators that limit the maximum achievable resolution of Analog-to-Digital Converters (ADCs), such as sigma delta ADCs. First order sigma delta converters are more susceptible to integrator leakage than higher order modulators. Often, first order sigma delta ADCs are preferred over higher order modulators due to their smaller size, equal weight allocation to each input sample, and ease of design (e.g., first order sigma delta ADC's are inherently stable).

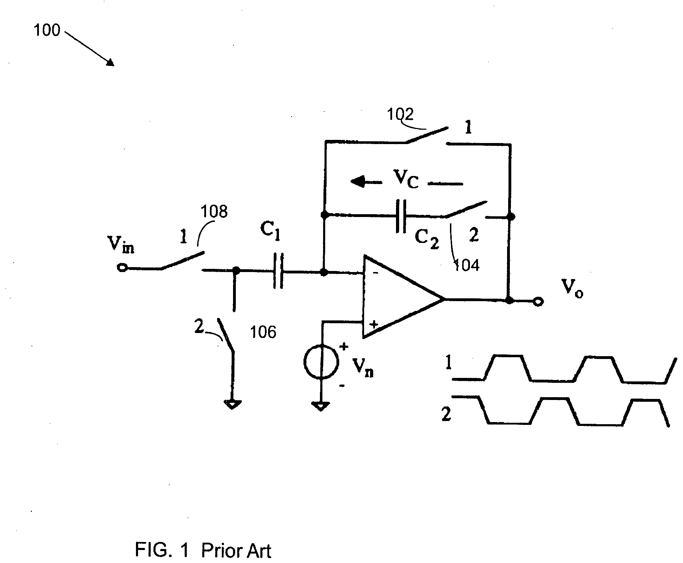

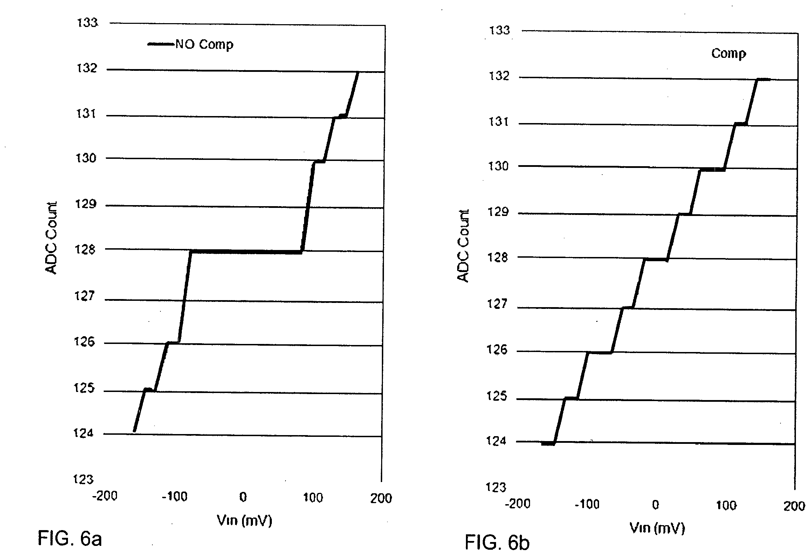

Integrator leakage results in dead zones of the ADC transfer curve. For example, large integral non-linearity (INL) errors may be introduced due to the leakage currents. First order sigma-delta ADCs employing the simplest CDS sampling scheme are therefore presently limited to 16 bit resolution. FIG. 1 illustrates a switched capacitor integrator, as described by T. Fulop, and F. Montecchi, Switched Capacitor Biquad Building Block with Offset-Insensitive Time-Continuous Feedback Integrators, IEEE, 1988. The corresponding ADC transfer curve is illustrated in FIG. 6a, which is discussed later.

The CDS integrator circuit 100 is sensitive to parasitic capacitances across the integration switches 102, 104, 106, and 108. For example, in phase 1, the parasitic capacitance of the reset switch 102 is discharged. In phase 2, the parasitic capacitance of switch 102 is in parallel with the integration capacitor C2. Due to the charge redistribution (e.g., from C2 to the parasitic capacitance of switch 102), a portion of the integrated signal is therefore lost.

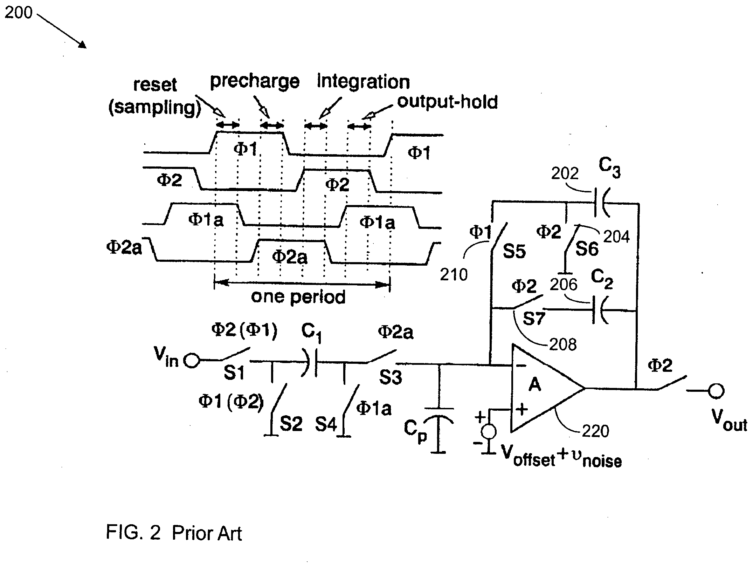

FIG. 2 illustrates a switched capacitor integrator, as described by T. Kajita, G. Temes, and U. Moon, Correlated Double Sampling Integrator Insensitive to Parasitic Capacitance, Electronic Letters, February 2001, Vol. 37 No. 3. Circuit 200 uses an additional capacitor 202, which is of the same size (e.g., capacitance) as the integration capacitor 206, to desensitize the circuit 200 to the parasitic capacitance of the integration switches (i.e., 204, 208, and 210). In phase 2, the capacitor 202 additionally loads the output of the amplifier 220, thereby causing bandwidth constraints when used with single stage amplifiers.

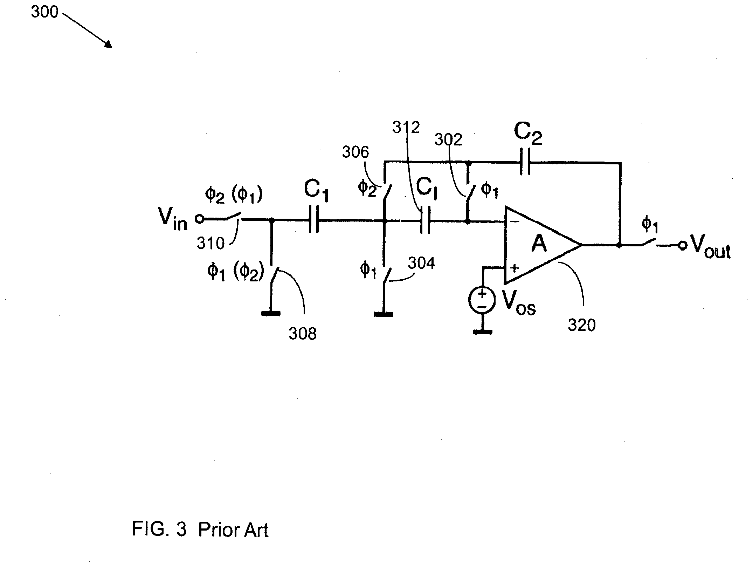

FIG. 3 illustrates a switched capacitor integrator, as described by C. Enz and G. Temes, Circuit Techniques for Reducing the Effects of Op-Amp Imperfections: Autozeroing, Correlated Double Sampling, and Chopper Stabilization, IEEE, Vo. 84. Nov. 1996. Circuit 300 uses an additional capacitor 312 to store the offset of the amplifier 320. Mismatch of the sampling switches 302, 304, 306, 308 and 310 results in non-ideal offset compensation that ultimately leads to an integration signal that is partially offset.

Accordingly, known correlated double sampling integrators typically have a low sensitivity to the parasitic capacitance of the integration switches. Traditional ways of addressing this concern resulted in more complex circuits that use more real estate by including an additional capacitor of the same size as the integration capacitor, an offset storing capacitor, and/or a much larger number of active sampling switches. It would be desirable to provide circuits and methods for a switched capacitor integrator that avoids these problems.

EP 0 293 020 A1 relates to an amplification circuit comprising an operational amplifier and two groups of capacitances in input and feedback association with the operational amplifier. 2-phase switching means are periodically switched between a position in which two other capacitance groups are charged at output voltage values equal but opposite in sign and a position in which said other capacitances cancel each other out.

US 6,172,631 B1 relates to a bandpass filter with an input terminal including a sampling circuit for double sampling an input signal from said input terminal, an amplifier, and a conductive connection circuit show input terminal is coupled to an output of said amplifier, for successively forming three different stages of conductive connection during a time period to form a filtering device with said amplifier.

## BRIEF DESCRIPTION OF DRAWINGS

The drawings are of illustrative embodiments. They do not illustrate all embodiments. Other embodiments may be used in addition or instead. Details that may be apparent or unnecessary may be omitted to save space or for more effective illustration. Some embodiments may be practiced with additional components or steps and/or without all of the components or steps that are illustrated. When the same numeral appears in different drawings, it refers to the same or like components or steps.

FIG. 1 illustrates a conventional switched capacitor integrator without leakage compensation.

FIG. 2 illustrates a conventional switched capacitor integrator that accommodates leakage compensation via a large capacitor that limits the bandwidth.

FIG. 3 illustrates a conventional switched capacitor integrator that accommodates leakage compensation with a compensation capacitor that leads to an offset.

FIG. 4a illustrates a CDS switched capacitor integrator without leakage compensation.

FIG. 4b illustrates the phase timing diagram for the circuit of FIG. 4a.

FIG. 5 illustrates an exemplary differential CDS switched capacitor integrator circuit that includes dummy capacitive elements, consistent with an embodiment of the present disclosure.

FIG. 6a illustrates an exemplary transfer curve for an ADC that does not compensate for the parasitic capacitance of the integration switches.

FIG. 6b illustrates an exemplary transfer curve for an ADC that compensates for the parasitic capacitance of the integration switches, consistent with an embodiment of the present disclosure.

## DETAILED DESCRIPTION OF ILLUSTRATIVE EMBODIMENTS

In the following detailed description, numerous specific details are set forth by way of examples in order to provide a thorough understanding of the relevant teachings. However, it should be apparent that the present teachings may be practiced without such details. In other instances, well-known methods, procedures, components, and/or circuitry have been described at a relatively high-level, without detail, in order to avoid unnecessarily obscuring aspects of the present teachings.

The various methods and circuits disclosed herein relate to differential CDS switched capacitor (SC) integrator circuits that compensate for leakage in the integration capacitor. In accordance with one aspect of the present disclosure, the SC circuit includes a differential amplifier having inverting and non-inverting inputs and positive and negative outputs. First and second integration capacitors are respectively coupled to the positive and negative outputs. The differential amplifier has a first feedback path between its positive output and its negative input, and a second feedback path between its negative output ands its positive input. Each feedback path has an integration capacitor and one or more integration switches. These integration switches have inherent parasitic capacitance that share the charge with their respective integration capacitors. Capacitive elements are cross coupled between the inputs and outputs of the amplifier, thereby substantially compensating for any charge lost due to the parasitic capacitance of the integration switches.

The capacitive elements may comprise dummy switches that are configured to provide capacitance for com-

EP 2 779 444 B1

pensating for signal loss due to parasitic capacitance of the integration switches. Each dummy switch may be a passive switch that is always open. By using a dummy switch as a capacitive element, the parasitic capacitance of the integration switches can be better tracked and then canceled. For example, the dummy switch has a capacitance that tracks the capacitance of the integration switches over chip process variation, operating temperature changes, and aging.

Thus, each dummy switch is configured to provide parasitic capacitance that is as large (e.g., same capacitance) as the parasitic capacitance associated with the integration switches. For example, each dummy switch may be implemented by a pair of parallel connected transistors similar to a transistor used for each of the integration switches. Metal oxide semiconductor field effect transistors (MOSFETs) may be used for implementing both the dummy switches and the integration switches. For example, the capacitance between the source to drain of the MOSFET dummy switch is used to emulate the parasitic capacitance of the integration switches.

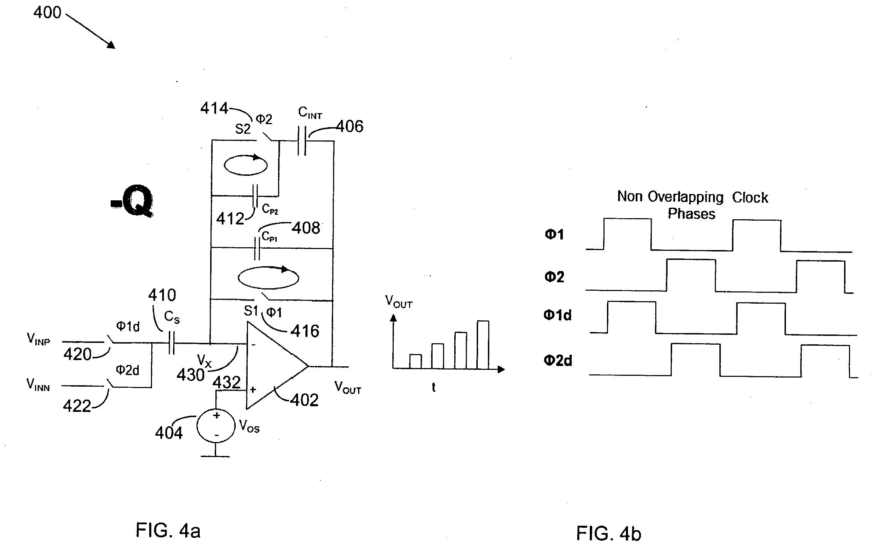

Reference now is made in detail to the examples illustrated in the accompanying drawings and discussed below. FIG. 4a illustrates an exemplary CDS switched capacitor integrator 400 that includes an operational amplifier 402, an integration switch S1 (416) coupled between an inverting input of the amplifier 430 and its output $V_{OUT}$, and an integration switch S2 (414) coupled between the inverting input 430 of the amplifier 402 and an integration capacitor $C_{INT}$ (406) that is coupled to the output $V_{OUT}$. A sampling capacitor Cs (410) is coupled between the inverting input 430 of the amplifier 402 and a pair of parallel input switches 420 and 422. The pair of input switches are supplied with input voltages $V_{INP}$ and $V_{INN}$. There is an offset voltage Vos at the non-inverting input 404 of the amplifier 402. Due to the virtual short between the non-inverting input 432 and the inverting input 430 of the amplifier 402, the offset voltage appears on the non-inverting input 430. The offset voltage is discussed in more detail later.

Further, FIG. 4a illustrates parasitic capacitance $C_{P1}$ (408) associated with the switch S1 (416) and parasitic capacitance $C_{P2}$ (412) associated with the switch S2 (414). The parasitic capacitances $C_{P1}$ (408) and $C_{P2}$ (412) are in parallel to the switches S1 (416) and S2 (414), respectively.

Circuit 400 is best understood in reference with FIG. 4b, which shows a timing diagram illustrating clock phases of the integrator 400. During phase $\Phi 1$, the operational amplifier 402 is in unity gain configuration because switch S1 (416) is closed while switch S2 (414) is open. Since switch 420 is closed, the sampling capacitor Cs 410 is charged to $V_{INP} - V_{OS}$, while the parasitic capacitance of switch S1 (i.e., $C_{P1}$) is discharged. During the same phase $\Phi 1$, the parasitic capacitance of switch S2 (i.e., $C_{P2}$) is charged to the voltage on integration capacitor $C_{INT}$ 406 via charge redistribution. Put differently, when switch S2 (414) is open, its parasitic capacitance $C_{P2}$ (412) removes charge from the integration capacitor $C_{INT}$ (406) through charge redistribution.

During phase $\Phi 2$, the reset switch S1 (416) opens and switch S2 (414) closes, thereby creating a path between the integration capacitor $C_{INT}$ (406) and node Vx (i.e., the inverting input of amplifier 402). Further, the parasitic capacitance of switch S2 (i.e., $C_{P2}$) is dicharged via switch S2 (414) since it is now closed. During this phase $\Phi 2$, switch 420 is open while switch 422 is closed. Thus, sampling capacitor Cs 410 is connected to input $V_{INN}$. The charge that is integrated by operational amplifier 402 is provided by equation 1 below:

$$Q \approx C_S / (V_{INP} - V_{INN}) \qquad [EQ. \ 1]$$

Closing switches S1 (416) or S2 (414), which are in parallel with their parasitic capacitances $C_{P1}$ and $C_{P2}$, respectively, leads to signal loss. For example, during $\Phi 1$, the parasitic capacitance CP1 of switch S1 (416) is discharged. However, during phase $\Phi 2$, where switch S1 (416) is in parallel with the integration capacitor $C_{INT}$ (406), discharged parasitic capacitance CP1 of switch S1 (416) shares the charge of the integration capacitor $C_{INT}$ through charge sharing. The charge lost during one sampling period is estimated by equation 2 below:

$$-Q \ _{(lost \ during \ a \ sampling \ period)} \approx V_{OUT} / (2 C_P) \qquad [EQ. \ 2]$$

where:

  $V_{OUT}$ is the voltage at the output of the amplifier 402
  $C_P$ is the respective parasitic capacitance of the switch

Thus, unless the signal that was stored across integration capacitor $C_{INT}$ (406) was 0V, there is a charge sharing concern that reduces the accuracy of the integration circuit 400. This leakage effect is sometimes referred to as a leaky integrator.

Thus, the signal (e.g., charge) lost during a sampling interval is a function of the parasitic capacitance of the switches (e.g., CP1 and CP2) and the signal stored in the integration capacitor. If switches S1 (416) and S2 (412) are of equal size then $C_{P1} = C_{P2}$, represented herein as $C_P$. Accordingly, the charge lost (-Q) is a quantity that can be calculated. What is needed is a positive charge (e.g., +Q) to counteract the charge lost due to the charge sharing discussed above.

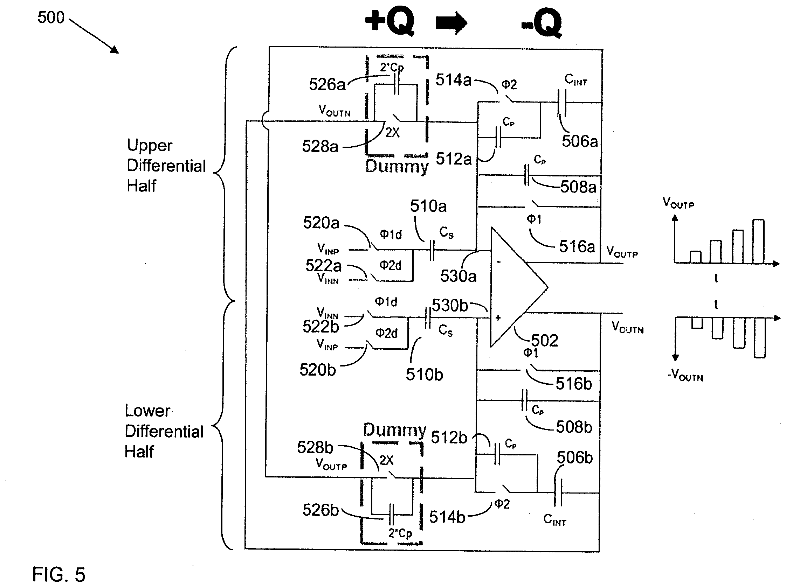

In a fully differential switched capacitor integrator circuit, the outputs are of equal magnitude but of opposite polarity (e.g., $V_{OUTP} = -V_{OUTN}$). If each differential input includes an element that tracks the parasitic capacitance of the switches and each such element is cross coupled to the differential output, respectively, an equal but opposite charge (+Q) is added to each positive and negative feedback loop of the amplifier 402, respectively. This opposite charge (+Q) counteracts the charge lost (-Q) due to the charge sharing of the integration switches with the integration capacitor. This concept is better described below in the context of FIG. 5.

FIG. 5 illustrates an exemplary differential CDS switched capacitor integrator circuit that includes dummy capacitive elements, consistent with an embodiment of the present disclosure. Circuit 500 includes an upper half and a lower half, which are mutually similar. The two halves can be viewed as single-ended sample circuits that have been matted together to form a differential configuration. Accordingly, some aspects of circuit 500 will be discussed in the context of the upper half and not repeated for the bottom half for brevity.

Circuit 500 includes an operational amplifier 502, an integration switch 516a coupled between a negative (inverting) input of the amplifier 502 and its positive output node $V_{OUTP}$, and an integration switch 514a coupled between the negative (inverting) input 530a of the amplifier 502 and an integration capacitor 506a that is coupled to the positive output node $V_{OUTP}$. A sampling capacitor Cs (510a) is coupled between the negative input node 530a of the amplifier 502 and a pair of parallel input switches 520a and 522a. The pair of input switches are supplied with input voltages $V_{INP}$ and $V_{INN}$, respectively.

Circuit 500 includes a capacitive element 528a that is coupled between the negative input node 530a and the negative output node $V_{OUTN}$ of the amplifier 502. By way of example, the capacitance of the capacitive element 528a is illustrated separately (i.e., in parallel) as a capacitor 526a. Similarly, the lower differential half includes a capacitive element 526b that is coupled between the positive input node 530b and the positive output node $V_{OUTP}$ of the amplifier 502. The capacitive element 528a is configured to cancel the parasitic capacitance of the 512a and 508a of switches 514a and 516a, respectively. The capacitance of the capacitive element 528a equals the total parasitic capacitance of switches 514a and 516a. For example, if switches 514a and 516a are of similar size (and thus have equal parasitic capacitance Cp), then the capacitance of the capacitive element 528a is 2 X $C_P$.

Thus, the capacitive element 528a may be a dummy switch that has the total capacitance of switches 516a and 512a. The dummy switches discussed herein may be passive switches (e.g., they are always open). In various embodiments, switches may be used to better track the capacitance of the switches 516a. For example, switches 516a and 514a, as well as dummy switch 528a may be MOSFET switches. The drain to source capacitance of a MOSFET may be used to implement the capacitive element 528a In one embodiment, the dummy switch 528a may comprise a MOSFET having a channel width that is twice the channel width of the MOSFET used for switch 516a or 514a. In another embodiment, the dummy switch 528a may comprise a pair of MOSFETs connected in parallel (e.g., one for each switch 514a and 516a).

Since the dummy switch 528a and the switches 516a and 514a have a similar structure, the dummy switch 528a can better track the process, temperature, and even degradation (e.g., aging) of the capacitance of the switches 516a and 514a. In addition, the dummy switch may have a substantially similar layout as switches 514a and 516a for even better tracking of the parasitic capacitance. Thus, if the capacitance of switches 514a and 516a varies, the dummy switch 528a tracks the variation in its own capacitance 526a due to its similar structure and size.

The size of each dummy switch may be selected so as to provide dummy parasitic capacitance 2*$C_P$, which is about two times larger than the parasitic capacitance $C_P$ of each integration switch (i.e., when the switches 516a and 512a have equal capacitance). Put differently, dummy switch 528 has a capacitance that is equal to the total capacitance of the switches 512a and 516a.

FIG. 6a illustrates an exemplary transfer curve for an ADC that does not compensate for the parasitic capacitance of the integration switches, such as that of circuit 100. The curve in FIG. 6a highlights the nonlinearity and imprecision of an ADC that does not accommodate for the charge sharing effect of the integration switches.

In contrast FIG. 6b illustrates an exemplary transfer curve for an ADC that compensates for the parasitic capacitance of the integration switches by including dummy capacitances. These dummy capacitances are cross-coupled to the output to provide a charge that is substantially equal in magnitude but opposite in polarity to the charge lost due to charge sharing from the respective switches that are being compensated. FIG. 6b illustrates that the linearity and accuracy is improved when the charge lost due to the parasitic capacitance of the integration switches is compensated for using the concepts described herein.

The components, steps, features, objects, benefits and advantages that have been discussed herein are merely illustrative. None of them, nor the discussions relating to them, are intended to limit the scope of protection. Unless otherwise stated, all measurements, values, ratings, positions, magnitudes, sizes, and other specifications that are set forth in this specification, including in the claims that follow, are approximate, not exact. They are intended to have a reasonable range that is consistent with the functions to which they relate and with what is customary in the art to which they pertain.

Numerous other embodiments are also contemplated. These include embodiments that have fewer, additional, and/or different components, steps, features, objects, benefits and advantages. These also include embodiments in which the components and/or steps are arranged and/or ordered differently. For example, any signal discussed herein may be scaled, buffered, scaled and buffered, converted to another mode (e.g., voltage, current, charge, time, etc.,), or converted to another state (e.g., from HIGH to LOW and LOW to HIGH) without materially changing the underlying control method. Further, bipolar transistors (e.g., PNP or NPN) can be used instead of MOS transistors. A PNP may be used instead of NPN, and a PMOS may be used instead of NMOS. Accordingly, it is intended that the invention be limited only in terms of the appended claims. The systems described herein could be converted to equivalent digital logic functions and yet be within the scope of the same method.

The scope of the appended claims is intended and should be interpreted to be as broad as is consistent with the ordinary meaning of the language that is used in the claims when interpreted in light of this specification.

Except as stated immediately above, nothing that has been stated or illustrated is intended or should be interpreted to cause a dedication of any component, step, feature, object, benefit, advantage, to the public, regardless of whether it is or is not recited in the claims.

It will be understood that the terms and expressions used herein have the ordinary meaning as is accorded to such terms and expressions with respect to their corresponding respective areas of inquiry and study except where specific meanings have otherwise been set forth herein. Relational terms such as first and second and the like may be used solely to distinguish one entity or action from another without necessarily requiring or implying any actual such relationship or order between such entities or actions. The terms "comprises," "comprising," or any other variation thereof, are intended to cover a non-exclusive inclusion, such that a process, method, system, or apparatus that comprises a list of elements does not include only those elements but may include other elements not expressly listed or inherent to such process, method, system, or apparatus. An element proceeded by "a" or "an" does not, without further constraints, preclude the existence of additional system elements in the process, method, system, or apparatus that comprises the element.

The Abstract of the Disclosure is provided to allow the reader to quickly ascertain the nature of the technical disclosure. It is submitted with the understanding that it will not be used to interpret or limit the scope or meaning of the claims. In addition, in the foregoing Detailed Description, it can be seen that various features are grouped together in various embodiments for the purpose of streamlining the disclosure. This method of disclosure is not to be interpreted as reflecting an intention that the claimed embodiments require more features than are expressly recited in each claim. Rather, as the following claims reflect, inventive subject matter lies in less than all features of a single disclosed embodiment.

**Claims**

1. A differential correlated double sampling - CDS - switched capacitor integrator circuit (500), comprising:

   a differential amplifier (502), comprising:

   a differential input having a negative and a positive input node (530a, 530b);
   a differential output having a negative and a positive output node ($V_{OUTN}$, $V_{OUTP}$);
   a first feedback path between the positive output node ($V_{OUTP}$) and the negative input node (530a), comprising:

   an integration capacitor (506a); and
   at least one integration switch (516a, 514a) having a parasitic capacitance (508a, 512a);
   a second feedback path between the negative output node ($V_{OUTN}$) and the positive input node (530b), comprising:

   an integration capacitor (506b); and
   at least one integration switch (516b, 514b) having a parasitic capacitance (508b, 512b);
   a first capacitive element (528a) coupled between the negative input node (530a) and the negative output node ($V_{OUTN}$), having a capacitance (526a) equal to the total parasitic capacitance (508a, 512a) of the at least one integration switch (516a, 514a) of the first feedback path and configured to cancel the parasitic capacitance (508a, 512a) of the at least one integration switch (516a, 514a) of the first feedback path; and

a second capacitive element (528b) coupled between the positive input node (530b) and the positive output node ($V_{OUTP}$), having a capacitance (526b) equal to the total parasitic capacitance (508b, 512b) of the at least one integration switch (516b, 514b) of the second feedback path and configured to cancel the parasitic capacitance (508b, 512b) of the at least one integration switch (516b, 514b) of the second feedback path.

2. The circuit (500) of claim 1, wherein:

the first capacitive element (528a) is a dummy switch that has a capacitance (526a) equal to the total capacitance (508a, 512a) of the at least one integration switch (516a, 514a) in the first feedback path; and
the second capacitive element (528b) is a dummy switch that has a capacitance (526b) equal to the total capacitance (508b, 512b) of the at least one integration switch (516b, 514b) in the second feedback path.

3. The circuit (500) of claim 1 or 2, wherein each integration switch (516a, 514a, 516b, 514b) and dummy switch (528a, 528b) is a metal oxide semiconductor field effect transistor - MOSFET.

4. The circuit (500) of claim 2 or 3, wherein a drain to source capacitance of each dummy MOSFET switch (528a, 528b) has the total capacitance of the at least one integration switch (516a, 514a, 516b, 514b) in the first and second feedback path, respectively.

5. The circuit (500) of any of the preceding claims, wherein:

the first and second capacitive elements (528a, 528b) are configured to track the parasitic capacitance (508a, 512a, 508b, 512b) of the at least one integration switch (516a, 514a, 516b, 514b) in the first and second feedback paths, respectively, over at least one of:

(i) a process change;
(ii) a temperature change; and
(iii) an aging of the circuit.

6. The circuit (500) of any of the preceding claims, wherein:

the at least one integration switch (516a, 514a) in the first feedback path comprises:

a first integration switch (516a) coupled between the positive output node ($V_{OUTP}$) and the negative input node (530a); and
a second integration switch (514a) coupled in series between the first input node (530a) and the integration capacitor (506a) ; and
the at least one integration switch (516b, 514b) in the second feedback path comprises:

a first integration switch (516b) coupled between the negative output node ($V_{OUTN}$) and the positive input node (530b); and
a second integration switch (514b) coupled in series between the second input node (530b) and the integration capacitor (506b).

7. The circuit (500) of claim 6, wherein in both the first and the second feedback paths, the first and second integration switches (516a, 516b, 514a, 514b) are of equal size and have a same parasitic capacitance (508a, 508b, 512a, 512b), respectively.

8. The circuit (500) of claim 6 or 7, wherein:

the first capacitive element (528a) has a capacitance (526a) equal to twice the parasitic capacitance (508a) of the first integration switch (516a) of the first feedback path; and
the second capacitive element (528b) has a capacitance (526b) equal to twice the parasitic capacitance (508b) of the first integration switch (516b) of the second feedback path.

**9.** The circuit (500) of claim 6 or 7, wherein a capacitance (526a, 526b) of the first and second capacitive elements (528a, 528b) are equal.

**10.** The circuit (500) of any of claims 3-9, wherein a channel width of the first and second dummy MOSFET switches (528a, 528b) is each twice a channel width of the at least one integration switch (516a, 514a, 516b, 514b) of the first and second feedback path, respectively.

**11.** The circuit (500) of any of claims 3-9, wherein the first and second dummy MOSFET switches (528a, 528b) each comprise a pair of MOSFETs having a same size as the at least one integration switch (516a, 514a, 516b, 514b) in the first and second feedback path, respectively.

**12.** A method of canceling parasitic capacitance (508a, 512a, 508b, 512b) of at least one integration switch (516a, 514a, 516b, 514b) in first and second feedback paths, respectively, in differential correlated double sampling - CDS - switched capacitor integrator circuit (500), comprising:

a differential amplifier (502), comprising:

the first feedback path between the positive output node ($V_{OUTP}$) and the negative input node (530a), comprising:

an integration capacitor (506a); and
at least one integration switch (516a, 514a) having a parasitic capacitance (508a,512a);
the second feedback path between the negative output node ($V_{OUTN}$) and the positive input node (530b), comprising:

an integration capacitor (506b); and
at least one integration switch (516b, 514b) having a parasitic capacitance (508b,512b);
the method comprising:

providing a first capacitive element (528a) coupled between the negative input node (530a) and the negative output node ($V_{OUTN}$), having a capacitance (526a) equal to the total parasitic capacitance (508a, 512a) of the at least one integration switch (516a, 514a) of the first feedback path and configured to cancel the parasitic capacitance (508a, 512a) of the at least one integration switch (516a, 514a) of the first feedback path; and
providing a second capacitive element (528b) coupled between the positive input node (530b) and the positive output node ($V_{OUTP}$), having a capacitance (526b) equal to the total parasitic capacitance (508b, 512b) of the at least one integration switch (516b, 514b) of the second feedback path and configured to cancel the parasitic capacitance (508b, 512b) of the at least one integration switch (516b, 514b) of the second feedback path.

**13.** The method of claim 12, further comprising:

determining a charge lost due to a charge sharing between the integration capacitor (506a, 506b) and the at least one integration switch (516a, 514a, 516b, 514b) in the first feedback path and the second feedback path, respectively;
creating a first charge that is equal in magnitude but opposite in polarity to the charge lost in the first feedback path;
creating a second charge that is equal in magnitude but opposite in polarity to the charge lost in the second feedback path;
adding the first charge to the first feedback path and the second charge to the second feedback path.

**Patentansprüche**

**1.** Differentielle Schaltkondensator-Integratorschaltung (500) mit korrelierter Doppelabtastung - CDS, umfassend:

einen Differenzverstärker (502), umfassend:

einen Differenzeingang mit einem Minus- und einem Plus-Eingangsknoten (530a, 530b);

einen Differenzausgang mit einem Minus- und einem Plus-Ausgangsknoten ($V_{OUTN}$, $V_{OUTP}$);

einen ersten Rückkopplungspfad zwischen dem Plus-Ausgangsknoten ($V_{OUTP}$) und dem Minus-Eingangsknoten (530a), umfassend:

einen Integrationskondensator (506a); und
mindestens einen Integrationsschalter (516a, 514a), der eine parasitäre Kapazität (508a, 512a) aufweist;

einen zweiten Rückkopplungspfad zwischen dem Minus-Ausgangsknoten ($V_{OUTN}$) und dem Plus-Eingangsknoten (530b),
umfassend:

einen Integrationskondensator (506b); und
mindestens einen Integrationsschalter (516b, 514b), der eine parasitäre Kapazität (508b, 512b) aufweist;

ein erstes kapazitives Element (528a), das zwischen den Minus-Eingangsknoten (530a) und den Minus-Ausgangsknoten ($V_{OUTN}$) geschaltet ist und eine Kapazität (526a) aufweist, die gleich der gesamten parasitären Kapazität (508a, 512a) des mindestens einen Integrationsschalters (516a, 514a) des ersten Rückkopplungspfades ist,
und ausgestaltet ist, die parasitäre Kapazität (508a, 512a) des mindestens einen Integrationsschalters (516a, 514a) des ersten Rückkopplungspfades aufzuheben; und

ein zweites kapazitives Element (528b), das zwischen den Plus-Eingangsknoten (530b) und den Plus-Ausgangsknoten ($V_{OUTP}$) geschaltet ist und eine Kapazität (526b) aufweist, die gleich der gesamten parasitären Kapazität (508b, 512b) des mindestens einen Integrationsschalters (516b, 514b) des zweiten Rückkopplungspfades ist,
und ausgestaltet ist, die parasitäre Kapazität (508b, 512b) des mindestens einen Integrationsschalters (516b, 514b) des zweiten Rückkopplungspfades aufzuheben.

2.  Schaltung (500) nach Anspruch 1, wobei

das erste kapazitive Element (528a) ein Dummy-Schalter ist, der eine Kapazität (526a) aufweist, die gleich der Gesamtkapazität (508a, 512a) des mindestens einen Integrationsschalters (516a, 514a) im ersten Rückkopplungspfad ist; und

das zweite kapazitive Element (528b) ein Dummy-Schalter ist, der eine Kapazität (526b) aufweist, die gleich der Gesamtkapazität (508b, 512b) des mindestens einen Integrationsschalters (516b, 514b) im zweiten Rückkopplungspfad ist.

3.  Schaltung (500) nach Anspruch 1 oder 2, wobei jeder Integrationsschalter (516a, 514a, 516b, 514b) und Dummy-Schalter (528a, 528b) ein Metall-Oxid-Halbleiter-Feldeffekttransistor - MOSFET - ist.

4.  Schaltung (500) nach Anspruch 2 oder 3, wobei die Drain-Source-Kapazität jedes Dummy-MOSFET-Schalters (528a, 528b) die Gesamtkapazität des mindestens einen Integrationsschalters (516a, 514a, 516b, 514b) im ersten bzw. zweiten Rückkopplungspfad hat.

5.  Schaltung (500) nach einem der vorhergehenden Ansprüche, wobei das erste und das zweite kapazitive Element (528a, 528b) ausgestaltet sind, der parasitären Kapazität (508a, 512a, 508b, 512b) des mindestens einen Integrationsschalters (516a, 514a, 516b, 514b) im ersten bzw. zweiten Rückkopplungspfad zu folgen und zwar während mindestens eines von:

(i) einer Prozessänderung;
(ii) einer Temperaturänderung; und
(iii) einer Alterung der Schaltung.

6.  Schaltung (500) nach einem der vorhergehenden Ansprüche, wobei der mindestens eine Integrationsschalter (516a, 514a) im ersten Rückkopplungspfad umfasst:

einen ersten Integrationsschalter (516a), der zwischen den Plus-Ausgangsknoten ($V_{OUTP}$) und den Minus-Eingangsknoten (530a) geschaltet ist; und

einen zweiten Integrationsschalter (514a), der in Reihe zwischen den ersten Eingangsknoten (530a) und den Integrationskondensator (506a) geschaltet ist; und

der mindestens eine Integrationsschalter (516b, 514b) im zweiten Rückkopplungspfad umfasst:

einen ersten Integrationsschalter (516b), der zwischen den Minus-Ausgangsknoten ($V_{OUTN}$) und den Plus-Eingangsknoten (530b) geschaltet ist; und
einen zweiten Integrationsschalter (514b), der in Reihe zwischen den zweiten Eingangsknoten (530b) und den Integrationskondensator (506b) geschaltet ist.

7. Schaltung (500) nach Anspruch 6, wobei in beiden, nämlich im ersten und im zweiten Rückkopplungspfad, der erste und der zweite Integrationsschalter (516a, 516b, 514a, 514b) jeweils von gleicher Größe sind und eine gleiche parasitäre Kapazität (508a, 508b, 512a, 512b) aufweisen.

8. Schaltung (500) nach Anspruch 6 oder 7, wobei
das erste kapazitive Element (528a) eine Kapazität (526a) aufweist, die gleich dem Zweifachen der parasitären Kapazität (508a) des ersten Integrationsschalters (516a) des ersten Rückkopplungspfades ist; und das zweite kapazitive Element (528b) eine Kapazität (526b) aufweist, die gleich dem Zweifachen der parasitären Kapazität (508b) des ersten Integrationsschalters (516b) des zweiten Rückkopplungspfades ist.

9. Schaltung (500) nach Anspruch 6 oder 7, wobei die Kapazitäten (526a, 526b) des ersten und des zweiten kapazitiven Elements (528a, 528b) gleich sind.

10. Schaltung (500) nach einem der Ansprüche 3 bis 9, wobei die Kanalbreite des ersten und des zweiten Dummy-MOSFET-Schalters (528a, 528b) jeweils das Zweifache der Kanalbreite des mindestens einen Integrationsschalters (516a, 514a, 516b, 514b) des ersten bzw. zweiten Rückkopplungspfades ist.

11. Schaltung (500) nach einem der Ansprüche 3 bis 9, wobei der erste und der zweite Dummy-MOSFET-Schalter (528a, 528b) jeweils ein Paar MOSFETs gleicher Größe wie des mindestens einen Integrationsschalters (516a, 514a, 516b, 514b) im ersten bzw. zweiten Rückkopplungspfad umfasst.

12. Verfahren zum Aufheben der parasitären Kapazität (508a, 512a, 508b, 512b) mindestens eines Integrationsschalters (516a, 514a, 516b, 514b) im ersten bzw. zweiten Rückkopplungspfad in der differentiellen Schaltkondensator-Integratorschaltung (500) mit korrelierter Doppelabtastung - CDS umfassend:

einen Differenzverstärker (502), umfassend:

den ersten Rückkopplungspfad zwischen dem Plus-Ausgangsknoten ($V_{OUTP}$) und dem Minus-Eingangsknoten (530a), umfassend:

einen Integrationskondensator (506a); und
mindestens einen Integrationsschalter (516a, 514a), der eine parasitäre Kapazität (508a, 512a) aufweist;
den zweiten Rückkopplungspfad zwischen dem Minus-Ausgangsknoten ($V_{OUTN}$) und dem Plus-Eingangsknoten (530b), umfassend:

einen Integrationskondensator (506b); und
mindestens einen Integrationsschalter (516b, 514b), der eine parasitäre Kapazität (508b, 512b) aufweist;
wobei das Verfahren umfasst:

Bereitstellen eines ersten kapazitiven Elements (528a), das zwischen den Minus-Eingangsknoten (530a) und den Minus-Ausgangsknoten ($V_{OUTN}$) geschaltet ist und eine Kapazität (526a) aufweist, die gleich der gesamten parasitären Kapazität (508a, 512a) des mindestens einen Integrationsschalters (516a, 514a) des ersten Rückkopplungspfades ist, und ausgestaltet ist, die parasitäre Kapazität (508a, 512a) des mindestens einen Integrationsschalters (516a, 514a) des ersten Rückkopplungspfades aufzuheben; und
Bereitstellen eines zweiten kapazitiven Elements (528b), das zwischen den Plus-Eingangsknoten (530b) und den Plus-Ausgangsknoten ($V_{OUTP}$) geschaltet ist und eine Kapazität (526b) aufweist, die gleich der gesamten parasitären Kapazität (508b, 512b) des mindestens einen Integrationsschalters (516b, 514b) des zweiten Rückkopplungspfades ist,

und ausgestaltet ist, die parasitäre Kapazität (508b, 512b) des mindestens einen Integrationsschalters (516b, 514b) des zweiten Rückkopplungspfades aufzuheben.

**13.** Verfahren nach Anspruch 12, ferner umfassend:

Bestimmen des Ladungsverlusts infolge einer Ladungsaufteilung zwischen dem Integrationskondensator (506a, 506b) und dem mindestens einen Integrationsschalter (516a, 514a, 516b, 514b) im ersten Rückkopplungspfad bzw. zweiten Rückkopplungspfad;
Erzeugen einer ersten Ladung, die dem Ladungsverlust im ersten Rückkopplungspfad betragsmäßig gleich, bezüglich der Polarität jedoch entgegengesetzt ist;
Erzeugen einer zweiten Ladung, die dem Ladungsverlust im zweiten Rückkopplungspfad betragsmäßig gleich, bezüglich der Polarität jedoch entgegengesetzt ist;
Zuführen der ersten Ladung dem ersten Rückkopplungspfad und der zweiten Ladung dem zweiten Rückkopplungspfad.

## Revendications

**1.** Circuit d'intégrateurs de condensateur commuté pour échantillonnage double corrélé (CDS) différentiel (500), comprenant :

un amplificateur différentiel (502), comprenant :

une entrée différentielle ayant un noeud d'entrée négatif et un noeud d'entrée positif (530a, 530b) ;
une sortie différentielle ayant un noeud de sortie négatif et un noeud de sortie positif ($V_{OUTN}$, $V_{OUTP}$) ;
un premier chemin de rétroaction entre le noeud de sortie positif ($V_{OUTP}$) et le noeud d'entrée négatif (530a), comprenant :

un condensateur d'intégration (506a) ; et
au moins un commutateur d'intégration (516a, 514a) ayant une capacitance parasitique (508a, 512a) ;
un second chemin de rétroaction entre le noeud de sortie négatif ($V_{OUTN}$) et le noeud d'entrée positif (530b), comprenant :

un condensateur d'intégration (506b) ; et
au moins un commutateur d'intégration (516b, 514b) ayant une capacitance parasitique (508b, 512b) ;
un premier élément capacitif (528a) couplé entre le noeud d'entrée négatif (530a) et le noeud de sortie négatif ($V_{OUTN}$), ayant une capacitance (526a) égale à la capacitance parasitique totale (508a, 512a) du au moins un commutateur d'intégration (516a, 514a) du premier chemin de rétroaction et configuré pour annuler la capacitance parasitique (508a, 512a) du au moins un commutateur d'intégration (516a, 514a) du premier chemin de rétroaction ; et
un second élément capacitif (528b) couplé entre le noeud d'entrée positif (530b) et le noeud de sortie positif ($V_{OUTP}$), ayant une capacitance (526b) égale à la capacitance parasitique totale (508b, 512b) du au moins un commutateur d'intégration (516b, 514b) du second chemin de rétroaction et configuré pour annuler la capacitance parasitique (508b, 512b) du au moins un commutateur d'intégration (516b, 514b) du second chemin de rétroaction.

**2.** Circuit (500) selon la revendication 1, dans lequel :

le premier élément capacitif (528a) est un commutateur fictif qui possède une capacitance (526a) égale à la capacitance totale (508a, 512a) du au moins un commutateur d'intégration (516a, 514a) dans le premier chemin de rétroaction ; et
le second élément capacitif (528b) est un commutateur fictif qui possède une capacitance (526b) égale à la capacitance totale (508b, 512b) du au moins un commutateur d'intégration (516b, 514b) dans le second chemin de rétroaction.

**3.** Circuit (500) selon la revendication 1 ou 2, dans lequel chaque commutateur d'intégration (516a, 514a, 516b, 514b) et commutateur fictif (528a, 528b) est un transistor à effet de champ métal-oxyde semiconducteur - MOSTEC.

**4.** Circuit (500) selon la revendication 2 ou 3, dans lequel une capacitance drain-source de chaque commutateur MOSTEC fictif (528a, 528b) possède une capacitance totale du au moins un commutateur d'intégration (516a, 514a, 516b, 514b) dans les premier et second chemins de rétroaction, respectivement.

**5.** Circuit (500) selon l'une quelconque des revendications précédentes, dans lequel :

les premier et second éléments capacitifs (528a, 528b) sont configurés pour suivre la capacitance parasitique (508a, 512a, 508b, 512b) du au moins un commutateur d'intégration (516a, 514a, 516b, 514b) dans les premier et second chemins de rétroaction, respectivement, sur au moins un parmi :

(i) un changement de procédé ;
(ii) un changement de température ; et
(iii) un vieillissement du circuit.

**6.** Circuit (500) selon l'une quelconque des revendications précédentes, dans lequel :

le au moins un commutateur d'intégration (516a, 514a) dans le premier chemin de rétroaction comprend :

un premier commutateur d'intégration (516a) couplé entre le noeud de sortie positif ($V_{OUTP}$) et le noeud d'entrée négatif (530a) ; et
un second commutateur d'intégration (514a) couplé en série entre le premier noeud d'entrée (530a) et le condensateur d'intégration (506a) ; et
le au moins un commutateur d'intégration (516b, 514b) dans le second chemin de rétroaction comprend :

un premier commutateur d'intégration (516b) couplé entre le noeud de sortie négatif ($V_{OUTN}$) et le noeud d'entrée positif (530b) ; et
un second commutateur d'intégration (514b) couplé en série entre le second noeud d'entrée (530b) et le condensateur d'intégration (506b).

**7.** Circuit (500) selon la revendication 6, dans lequel, dans les premier et second chemins de rétroaction, les premier et second commutateurs d'intégration (516a, 516b, 514a, 514b) sont de dimensions égales et possèdent la même capacitance parasitique (508a, 508b, 512a, 512b), respectivement.

**8.** Circuit (500) selon la revendication 6 ou 7, dans lequel :

le premier élément capacitif (528a) possède une capacitance (526a) égale à deux fois la capacitance parasitique (508a) du premier commutateur d'intégration (516a) du premier chemin de rétroaction ; et
le second élément capacitif (528b) possède une capacitance (526b) égale à deux fois la capacitance parasitique (508b) du premier commutateur d'intégration (516b) du second chemin de rétroaction.

**9.** Circuit (500) selon la revendication 6 ou 7, dans lequel les capacitances (526a, 526b) des premier et second éléments capacitifs (528a, 528b) sont égales.

**10.** Circuit (500) selon l'une quelconque des revendications 3 à 9, dans lequel une largeur de canal des premier et second commutateurs MOSTEC fictifs (528a, 528b) est chacune deux fois une largeur de canal du au moins un commutateur d'intégration (516a, 514a, 516b, 514b) des premier et second chemins de rétroaction, respectivement.

**11.** Circuit (500) selon l'une quelconque des revendications 3 à 9, dans lequel les premier et second commutateurs MOSTEC fictifs (528a, 528b) comprennent chacun une paire de MOSTEC ayant une dimension identique à au moins un commutateur d'intégration (516a, 514a, 516b, 514b) dans les premier et second chemins de rétroaction, respectivement.

**12.** Procédé d'annulation d'une capacitance parasitique (508a, 512a, 508b, 512b) d'au moins un commutateur d'intégration (516a, 514a, 516b, 514b) dans des premier et second chemins de rétroaction, respectivement, dans un circuit d'intégrateurs de condensateur commuté pour échantillonnage double corrélé (CDS) différentiel (500), comprenant :

un amplificateur différentiel (502), comprenant :

**12**

le premier chemin de rétroaction entre le noeud de sortie positif ($V_{OUTP}$) et le noeud d'entrée négatif (530a), comprenant :

un condensateur d'intégration (506a) ; et
au moins un commutateur d'intégration (516a, 514a) ayant une capacitance parasitique (508a, 512a) ;
le second chemin de rétroaction entre le noeud de sortie négatif ($V_{OUTN}$) et le noeud d'entrée positif (530b), comprenant :

un condensateur d'intégration (506b) ; et
au moins un commutateur d'intégration (516b, 514b) ayant une capacitance parasitique (508b, 512b) ;
le procédé consistant à :

fournir un premier élément capacitif (528a) couplé entre le noeud d'entrée négatif (530a) et le noeud de sortie négatif ($V_{OUTN}$), ayant une capacitance (526a) égale à la capacitance parasitique totale (508a, 512a) du au moins un commutateur d'intégration (516a, 514a) du premier chemin de rétroaction et configuré pour annuler la capacitance parasitique (508a, 512a) du au moins un commutateur d'intégration (516a, 514a) du premier chemin de rétroaction ; et
fournir un second élément capacitif (528b) couplé entre le noeud d'entrée positif (530b) et le noeud de sortie positif ($V_{OUTP}$), ayant une capacitance (526b) égale à la capacitance parasitique totale (508b, 512b) du au moins un commutateur d'intégration (516b, 514b) du second chemin de rétroaction et configuré pour annuler la capacitance parasitique (508b, 512b) du au moins un commutateur d'intégration (516b, 514b) du second chemin de rétroaction.

13. Procédé selon la revendication 12, consistant en outre à :

déterminer une charge perdue en raison d'un partage de charge entre le condensateur d'intégration (506a, 506b) et le au moins un commutateur d'intégration (516a, 514a, 516b, 514b) dans le premier chemin de rétroaction et le second chemin de rétroaction, respectivement ;
créer une première charge qui est égale en magnitude, mais opposée en polarité, à la charge perdue dans le premier chemin de rétroaction ;
créer une seconde charge qui est égale en magnitude, mais opposée en polarité, à la charge perdue dans le second chemin de rétroaction ;
ajouter la première charge au premier chemin de rétroaction et la seconde charge au second chemin de rétroaction.

FIG. 1 Prior Art

FIG. 2 Prior Art

FIG. 3 Prior Art

400

-Q

414 Φ2    C_INT
S2         406
412  C_P2
C_P1   408

410
Φ1d   C_S
V_INP          S1  Φ1
420            416
V_X          V_OUT
Φ2d    430  432    402
V_INN              +
422
404    V_OS

FIG. 4a

V_OUT

t

Non Overlapping Clock
Phases

Φ1

Φ2

Φ1d

Φ2d

FIG. 4b

17

FIG. 5

FIG. 6b

FIG. 6a

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- EP 0293020 A1

- US 6172631 B1

### Non-patent literature cited in the description

- **T. FULOP ; F. MONTECCHI.** Switched Capacitor Biquad Building Block with Offset-Insensitive Time-Continuous Feedback Integrators. IEEE, 1988
- **T. KAJITA ; G. TEMES ; U. MOON.** Correlated Double Sampling Integrator Insensitive to Parasitic Capacitance. *Electronic Letters,* February 2001, vol. 37 (3

- **C. ENZ ; G. TEMES.** Circuit Techniques for Reducing the Effects of Op-Amp Imperfections: Autozeroing, Correlated Double Sampling, and Chopper Stabilization. IEEE, November 1996, vol. 84